# EUROPEAN PATENT APPLICATION

(11) **EP 2 099 069 A2**
(43) Date of publication of application: **09.09.2009**
(21) Application number: 09154366.0
(22) Date of filing: 04.03.2009
(51) Int. Cl.: H01L 23/467, F25B 9/04

(54) **Heat dissipator, in particular for electronic components**

(30) Priority: 04.03.2008 IT BO20080143
(71) Applicant: Pada Engineering - S.r.l., Saltara (IT)
(72) Inventor: Franchini, Fabio, 61032 Fano (IT); Savelli, Emiliano, 60019 Senigallia (IT)
(74) Representative: Jorio, Paolo

(57) **Abstract**

A heat dissipator for electronic components is provided with a vortex tube (18) to convert an input flow of compressed air into two output flows having a temperature higher and, respectively, lower than a temperature of the input flow and to supply the output flow at the lower temperature along a supply duct (10) obtained through a plate (2) defining a supporting surface (3) for at least one electronic component to be cooled.

## Description

The present invention relates to a heat dissipator, in particular for electronic components.

In the field of heat dissipators for electronic components, a prior art heat dissipator comprises a plate defining a supporting surface for at least one electronic component to be cooled, and a hydraulic water cooling circuit comprising, in turn, a first section obtained through the plate to cool the electronic component and a second section to cool the water flowing from said plate.

As the second section must be equipped with a heat exchanger provided with a cooling fan, the known heat dissipators of the type described above have some drawbacks mainly owing to the fact that the presence of said hydraulic cooling circuit makes said heat dissipators relatively complex and expensive.

It is an object of the present invention to provide a heat dissipator, in particular for electronic components, that overcomes the drawbacks described above and that is simple and economical to produce.

According to the present invention there is provided a heat dissipator, in particular for electronic components, according to the appended claims.

The present invention will now be described with reference to the accompanying drawings, illustrating a non-limiting embodiment thereof, in which:
figure 1 is a schematic plan view of a preferred embodiment of the heat dissipator according to the present invention;
figure 2 is a side view of the heat dissipator of figure 1;
figure 3 is a cross-section along the line III-III of figure 1; and
figure 4 is an axial view of a detail of figure 3.

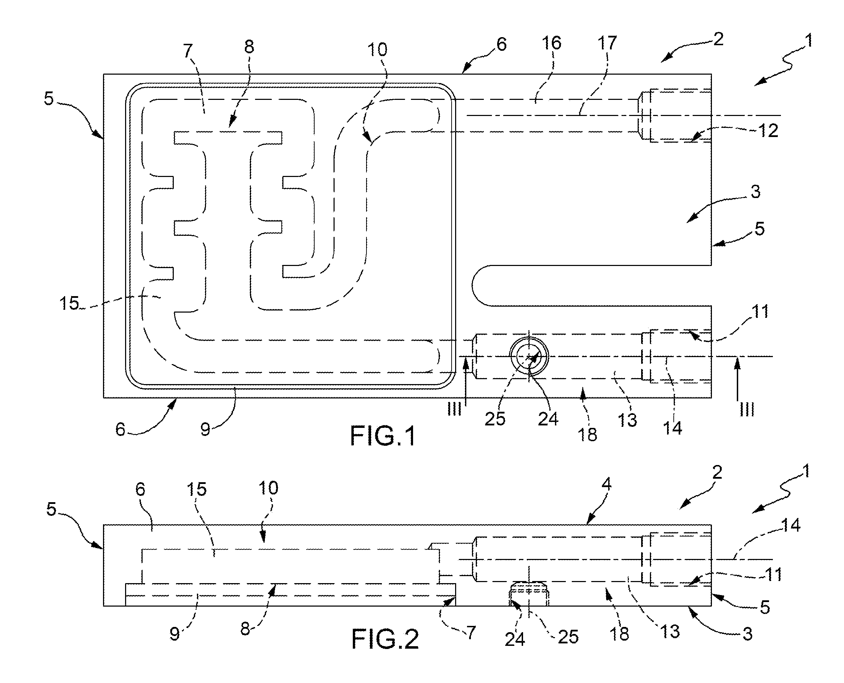

With reference to figures 1 and 2, designated as a whole by number 1 is a heat dissipator for electronic components (not illustrated) comprising, in the specific case, a plate 2 that is substantially parallelepiped in shape with a substantially rectangular cross-section having an upper face 3 and a lower face 4 parallel to one another, and of which the face 3 defines a supporting surface for at least one electronic component (not illustrated), two lateral faces 5 parallel to one another and orthogonal to the faces 3, 4, and two lateral faces 6 parallel to one another and orthogonal to the faces 3, 4 and 5.

The plate 2 comprises a substantially rectangular cavity 7, which is limited by a base wall 8 parallel to the faces 3, 4, and is closed in a fluid-tight manner by a flat cover 9 mounted in contact with said wall 8, and a supply duct 10 extending between an inlet 11 and an outlet 12 obtained on the same face 5.

The duct 10 comprises an inlet section 13, which is obtained through the plate 2 starting from the inlet 11, and has a substantially rectilinear longitudinal axis 14; a shaped intermediate section 15, which is obtained in correspondence with the cavity 7, is open towards the outside in correspondence with the wall 8, is closed superiorly by the cover 9, and communicates with the section 13; and an outlet section 16, which is obtained through the plate 2, extends between the section 15 and the outlet 12, and has a longitudinal axis 17 that is substantially rectilinear and parallel to the axis 14.

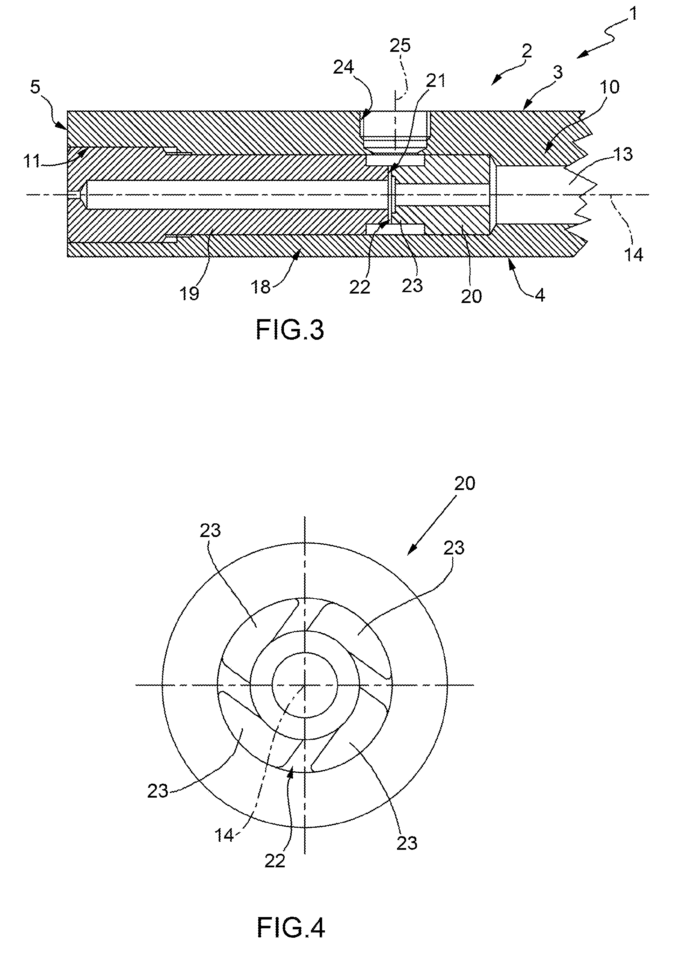

According to that illustrated in figure 3, the section 13 internally houses a vortex tube 18 comprising a tubular body 19 and a tubular coupling 20, which are coaxial with respect to the axis 14, and are mounted in sequence and in that order along the section 13 starting from the inlet 11.

The body 19 communicates with the atmosphere via the inlet 11, and is limited axially, in correspondence with an end thereof opposite said inlet 11, by a surface 21 substantially orthogonal to the axis 14, while the coupling 20 is limited axially, in correspondence with an end thereof facing the body 19, by a surface 22 substantially parallel to the surface 21, and having a plurality of teeth 23 (figure 4), which protrude axially from the surface 22, and are evenly distributed around the axis 14.

The tube 18 also comprises an inlet hole 24, which has a longitudinal axis 25 substantially orthogonal to the axis 14, is obtained through the plate 2 in a position facing the teeth 23, and is connected to a compressed air supply device that is known and is not illustrated.

In use, the teeth 23 of the coupling 20 impart a substantially spiral motion to the compressed air fed into the tube 18 through the inlet hole 24 that flows along the axis 14 so as to separate the input flow into two output flows, one of which is vented into the atmosphere through the body 19 and the other is supplied to the intermediate section 15 of the supply duct 10 through the coupling 20.

With regard to the above description it is important to note that the air flowing out of the body 19 is vented into the atmosphere at an output temperature that is higher than the temperature at which the air enters the tube 18 and that the air flowing out of the coupling 20 is supplied to the intermediate section 15 at an output temperature that is lower than the temperature at which the air enters the tube 18 in order to cool said electronic component (not illustrated).

According to an alternative embodiment that is not illustrated, the vortex tube 18 is arranged externally with respect to the plate 2, and is connected to the inlet 11 to supply the air flow at a lower temperature to the supply duct 10.

According to another alternative embodiment that is not illustrated, the heat dissipator 1 comprises a supporting plate similar to the plate 2 and provided with cooling fins that protrude from said supporting plate.

## Claims

1. Heat dissipator, in particular for electronic components, comprising a plate (2) defining a supporting surface (3) for at least one device to be cooled; a supply duct (10) obtained through the plate (2); and a supply device (18) to supply a cooling fluid along the supply duct (10); and **characterized in that** the supply device (18) comprises a vortex tube (18) which in turn comprises a separation chamber (19, 20), an inlet (24) through which a pressurized gas enters the separation chamber (19, 20), and a first and a second outlet (19, 20) through which two gas flows leave the separation chamber (19, 20) at a higher and, respectively, lower temperature than a temperature of the gas entering through said inlet (24); the second outlet (20) being connected to the supply duct (10).

2. Heat dissipator according to claim 1, wherein the first outlet (19) communicates with the atmosphere.

3. Heat dissipator according to claim 1 or 2, wherein the vortex tube (18) is arranged externally with respect to the plate (2).

4. Heat dissipator according to claim 1 or 2, wherein the vortex tube (18) is incorporated into the plate (2).

5. Heat dissipator according to any one of the previous claims, wherein the separation chamber (19, 20) and the inlet (24) have respective longitudinal axes (14, 25) that are substantially orthogonal to one another.

6. Heat dissipator according to any one of the previous claims, wherein the separation chamber (19, 20) and the two outlets (19, 20) are substantially coaxial with respect to one another.

7. Heat dissipator according to any one of the previous claims, wherein the vortex tube (18) comprises a generating member (20) to impart to the gas entering the separation chamber (19, 20) a motion directed substantially along a cylindrical vortex extending along said separation chamber (19, 20).

8. Heat dissipator according to claim 7, wherein the generating member (20) is cylindrical in shape, and is provided with a plurality of teeth (23), which protrude axially from an end surface (22) of the generating member (20), and are arranged in a position facing said inlet (24).

9. Heat dissipator according to any one of the previous claims, wherein the pressurized gas is compressed air.

10. Heat dissipator according to any one of the previous claims and also comprising a plurality of dissipation fins protruding from the plate (2).
